# EUROPEAN PATENT APPLICATION

(11) **EP 4 503 868 A1**
(43) Date of publication of application: **05.02.2025**
(21) Application number: 23778718.9
(22) Date of filing: 11.01.2023
(51) Int. Cl.: H05K 1/05, B29C 43/10, B29C 43/20, B29C 43/56, B32B 15/08

(54) **LAMINATE PRODUCTION METHOD**

(30) Priority: 28.03.2022 JP 2022051248
(71) Applicant: NHK Spring Co., Ltd., Yokohama-shi, Kanagawa 236-0004 (JP)
(72) Inventor: MIZUNO, Katsumi, Yokohama-shi, Kanagawa 236-0004 (JP); WATANABE, Toshinori, Yokohama-shi, Kanagawa 236-0004 (JP); SHIMOMURA, Kohei, Yokohama-shi, Kanagawa 236-0004 (JP); TOGA, Takashi, Yokohama-shi, Kanagawa 236-0004 (JP)
(74) Representative: TBK
(86) International application number: PCT/JP2023/000369
(87) International publication number: WO 2023/188678

(57) **Abstract**

The present invention relates to a laminate that includes a circuit pattern having a thickness of 0.8 mm or more, and a method for producing a laminate capable of preventing defects occurring in an insulating layer is proposed.

A method for producing a laminate (1) that is formed by lamination of a metal base substrate (2), an insulating layer (3) formed by curing a resin composition, and a circuit pattern (4) having a thickness of 1 mm or more includes a step of preparing a laminate before press bonding (1A) in which a semi-cured resin composition (3A) is interposed between the metal base substrate (2) and the circuit pattern (4), a step of covering the laminate before press bonding (1A) with a film (11) and placing the laminate before press bonding (1A) inside an autoclave (10), and a step of exhausting an inside atmosphere of the film (11) and increasing a temperature and a pressure inside the autoclave (10) to cure the semi-cured resin composition (3A).

## Description

### Technical Field

The present invention relates to a method for producing a laminate.

### Background Art

Conventionally, as a circuit board on which an electronic component such as a semiconductor chip is mounted, a laminate formed by lamination of a metal base substrate, an insulating layer, and a circuit pattern is known (see, for example, Patent Literature 1). Such a laminate is produced according to steps of, for example, preparing a resin composition obtained by mixing a resin and a filler, applying the resin composition onto a metal base substrate and performing pre-curing, and disposing a circuit pattern on the resin composition and performing hot pressing.

In recent years, the opportunities to use electronic components such as high-luminance LEDs and power modules through which a large current flow is increasing. In order to obtain a laminate with which this type of electronic component can be used in response to a large current, it is effective to increase the thickness of the circuit pattern to reduce a resistance value and ensure sufficient heat dissipation when the large current flows.

### Citation List

### Patent Literatures

Patent Literature 1: JP 2002-012653 A
Patent Literature 2: JP 2009-206225 A

### Summary of Invention

### Technical Problem

Moreover, in a case where hot pressing is carried out when the laminate is produced, the resin composition in contact with a conductive portion (metal portion) included in the circuit pattern is pressurized, while a gap portion located between conductive portions adjacent to each other is not in contact with the resin composition. Therefore, the pressurization on the resin composition in the gap portion is likely to be insufficient. That is, when the hot pressing is carried out, the pressure is unevenly applied to the resin composition depending on whether the resin composition is in contact with the conductive portion or not. Here, at the site where the gap portion is disposed, a gas contained in the resin composition cannot be discharged because the pressurization is insufficient, and a large number of voids thus occurs, which may result in failure to ensure insulation. In particular, in a case where the circuit pattern is thickened, the depth of the gap portion increases, and insufficient pressurization is remarkably caused, so that such a defect is likely to occur. At the site where the conductive portion is disposed, the resin composition may be strongly pushed by an end of the conductive portion (or a rapid pressure change occurs between the gap portion and the conductive portion with the end of the conductive portion serving as a boundary), thereby causing cracking when the resin composition is formed as an insulating layer.

When a material having irregularities on its surface is hot-pressed, a cushion material that acts to cover the irregularities may be used (see, for example, Patent Literature 2). However, in a case where the depth of the gap increases as described above, even with such a cushion material, it is difficult to sufficiently reach the depth of the gap. Therefore, insufficient pressurization may not be resolved. In particular, in a case where the circuit pattern has a thickness of 0.8 mm or more, the frequency of occurrence of such defects has increased.

In view of such problems, the present invention relates to a laminate that includes a circuit pattern having a thickness of 0.8 mm or more, and an object thereof is to provide a method for producing a laminate capable of preventing defects occurring in an insulating layer.

### Solution to Problem

The present invention is a method for producing a laminate that is formed by lamination of a metal base substrate, an insulating layer formed by curing a resin composition, and a circuit pattern having a thickness of 0.8 mm or more, the method including: a step of preparing a laminate before press bonding in which a semi-cured resin composition is interposed between the metal base substrate and the circuit pattern; a step of covering the laminate before press bonding with a film and placing the laminate inside an autoclave; and a step of exhausting an inside atmosphere of the film and increasing a temperature and a pressure inside the autoclave to cure the semi-cured resin composition.

The method for producing a laminate described above preferably further includes a step of applying a compressive force to the semi-cured resin composition, the step being carried out before the step of preparing the laminate before press bonding is performed.

In addition, in the method for producing a laminate, an increasing proportion of a weight-average molecular weight of the semi-cured resin composition after the step of applying the compressive force is preferably 30% or less based on an increasing proportion before the step of applying the compressive force.

Furthermore, in the method for producing a laminate, a density of the semi-cured resin composition after the step of applying the compressive force is preferably 85% or more based on an actual density of the insulating layer.

### Advantageous Effects of Invention

According to the method for producing a laminate of the present invention, it is possible to prevent defects occurring in the insulating layer in the laminate that includes the circuit pattern having a thickness of 0.8 mm or more.

### Brief Description of Drawings

Fig. 1 is a diagram illustrating a laminate produced by a method for producing a laminate according to an embodiment of the present invention.
Fig. 2 is a diagram illustrating the flow of the method for producing a laminate according to the embodiment of the present invention.
Fig. 3 is a diagram illustrating an example of an autoclave used in the method for producing a laminate according to the embodiment of the present invention.

### Description of Embodiment

Hereinafter, an embodiment of a method for producing a laminate according to the present invention will be described with reference to the accompanying drawings. The figures are schematically illustrated in the accompanying drawings, and the thickness and width of each portion, the ratio between the portions, and other parameters may be different from those actually implemented.

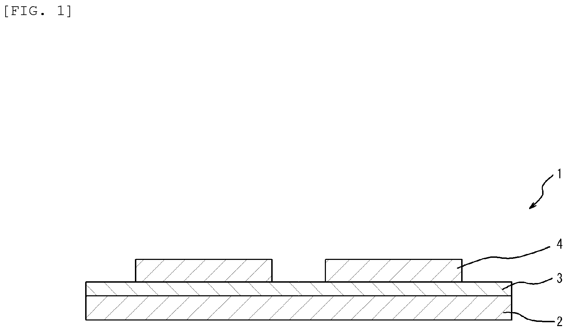

Fig. 1 is a diagram illustrating a laminate 1 produced by a production method of the present embodiment. The laminate 1 includes a metal base substrate 2, an insulating layer 3, and a circuit pattern 4.

The metal base substrate 2 is formed of, for example, a metal such as copper, aluminum, or iron (may be a single-component metal or an alloy). The metal base substrate 2 may have a single layer structure or a multilayer structure, or may be formed of a single member or a combination of a plurality of members. The metal base substrate 2 of the present embodiment may be sheet shaped, but may be a heat sink provided with comb-shaped fins. In addition, the metal base substrate 2 may have a configuration that improves an effect of releasing heat to the outside, and for example, may have a configuration in which a vapor chamber or a heat pipe is embedded in the metal sheet.

The insulating layer 3 is formed of a material having an insulating property, and is provided to cover a surface of the metal base substrate 2. The insulating layer 3 may cover the entire surface of the metal base substrate 2 or may cover a part of the surface.

The insulating layer 3 is formed of a resin composition containing a thermosetting resin. Examples of the thermosetting resin include an epoxy resin, a phenol resin, a melamine resin, a urea resin, an unsaturated polyester resin, an alkyd resin, a cyanate resin, and other resins. The thermosetting resin may be used alone, or two or more kinds thereof may be used in combination.

As the epoxy resin, regardless of a molecular weight and a molecular structure thereof, it is possible to use any of a monomer, an oligomer, or a polymer, which has two or more epoxy groups in one molecule. Specific examples of such an epoxy resin include bisphenol epoxy resins such as bisphenol A epoxy resins, bisphenol F epoxy resins, bisphenol E epoxy resins, bisphenol S epoxy resins, hydrogenated bisphenol A epoxy resins, bisphenol M epoxy resins (4,4'-(1,3-phenylenediisopridiene) bisphenol epoxy resins), bisphenol P epoxy resins (4,4'-(1,4-phenylenediisopridiene) bisphenol epoxy resins), bisphenol Z epoxy resins (4,4'-cyclohexydiene bisphenol epoxy resins); novolac epoxy resins such as phenol novolac epoxy resins, brominated phenol novolac epoxy resins, cresol novolac epoxy resins, tetraphenol group ethane novolac epoxy resins, and novolac epoxy resins having a fused ring aromatic hydrocarbon structure; biphenyl epoxy resins; aralkyl epoxy resins such as xylylene epoxy resins and biphenyl aralkyl epoxy resins; epoxy resins having a naphthalene skeleton such as naphthylene ether epoxy resins, naphthol epoxy resins, naphthalene epoxy resins, naphthalene diol epoxy resins, bifunctional or tetrafunctional epoxy naphthalene resins, binaphthyl epoxy resins, and naphthalene aralkyl epoxy resins; anthracene epoxy resins; phenoxy epoxy resins; dicyclopentadiene epoxy resins; norbornene epoxy resins; adamantane epoxy resins; heterocyclic epoxy resins such as fluorene epoxy resins, phosphorus-containing epoxy resins, alicyclic epoxy resins, aliphatic linear epoxy resins, bisphenol A novolac epoxy resins, bixylenol epoxy resins, triphenolmethane epoxy resins, trihydroxyphenylmethane epoxy resins, tetraphenylolethane epoxy resin, and triglycidyl isocyanurate; glycidyl amines such as N,N,N',N'-tetraglycidyl meta-xylene diamine, N,N,N',N'-tetraglycidyl bisaminomethylcyclohexane, and N,N-diglycidyl aniline, copolymers of glycidyl (meth)acrylate and compounds having ethylenically unsaturated double bonds, epoxy resins having a butadiene structure, diglycidyl ethers of bisphenols, diglycidyl ethers of naphthalenediol, and glycidyl ethers of phenols, and other resins. The epoxy resin may be used alone, or two or more kinds thereof may be used in combination.

The resin composition of the present embodiment is blended with a curing agent. The curing agent is not particularly limited as long as it is selected according to the type of thermosetting resin and reacts with the thermosetting resin. Examples of the curing agent in a case of using an epoxy resin include an amine-based curing agent, an imidazole-based curing agent, a phenol-based curing agent, and other curing agents.

The resin composition of the present embodiment is also blended with a filler (inorganic filler). The filler preferably has excellent insulation properties and high thermal conductivity, and examples thereof include aluminum oxide, silica, aluminum nitride, boron nitride, silicon nitride, magnesium oxide, and the like. The filler may be used alone, or two or more kinds thereof may be used in combination.

The resin composition of the present embodiment is further blended with a curing accelerator. The curing accelerator is not particularly limited, and examples thereof include organometallic salts such as benzoxazine compounds, borate complexes, zinc naphthenate, cobalt naphthenate, tin octylate, cobalt octylate, bisacetylacetonate cobalt (II), and triacetylacetonate cobalt (III); phenol compounds such as phenol, bisphenol A, and nonylphenol; tertiary amines, tertiary amine salts, phosphines, phosphonium salts, and the like.

The resin composition of the present embodiment is also blended with a solvent. The solvent is not particularly limited, and examples thereof include N-methylpyrrolidone, dimethylacetamide, tetrafluoroisopropanol, methyl ethyl ketone, ethylene diglycol acetate, propylene glycol monomethyl ether acetate, methyl isobutyl ketone, ethylene glycol monomethyl ether, tetrahydrofuran, chloroform, toluene, xylene, acetone, dioxane, dimethyl sulfoxide, and the like.

The resin composition may contain an additive. Examples of the additive include a stabilizer, an ion scavenger, and a softness imparting agent.

The circuit pattern 4 is obtained by forming a predetermined pattern using a material having conductivity. Examples of such a material include a metal sheet made of copper or aluminum. The thickness of the metal sheet (the thickness of the circuit pattern 4) is 0.8 mm or more. The upper limit of the thickness of the metal sheet (the thickness of the circuit pattern 4) is not particularly limited, but is, for example, 2.0 mm or less. Examples of a method for forming a predetermined pattern by using a metal sheet include a method for forming a mask pattern on a metal sheet to remove an exposed portion of the metal sheet by etching, and a method for punching a metal sheet by using a mold.

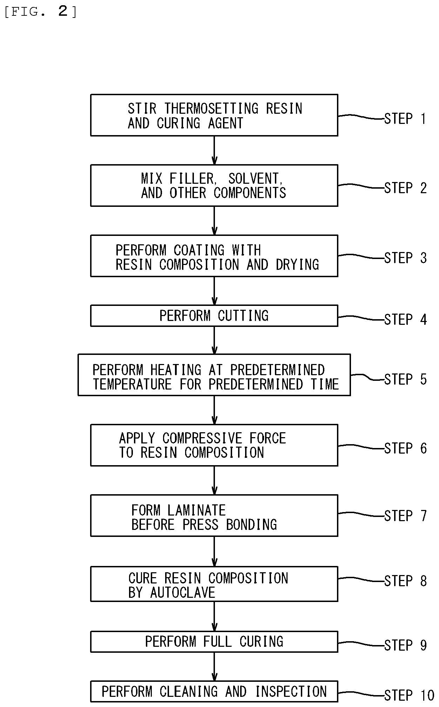

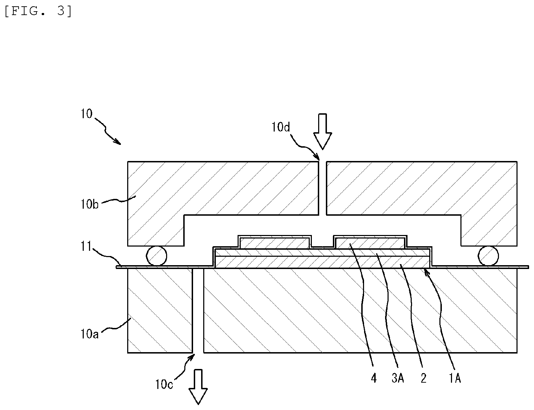

Next, a method for producing the laminate 1 will be described with reference to Figs. 2 and 3.

First, step 1 illustrated in Fig. 2 is carried out. In step 1, a thermosetting resin and a curing agent are placed in a container and stirred at a predetermined temperature for a predetermined time. As a result, the thermosetting resin and the curing agent can react with each other. Depending on the temperature during the stirring and the stirring time, the thermosetting resin and the curing agent that react with each other in step 1 can be brought in a prepolymer state, but this process may be appropriately selected depending on the curing degree of the thermosetting resin in a step described later, and it is not always necessary to bring the thermosetting resin and the curing agent in a prepolymer state in step 1.

In step 2, the stirred thermosetting resin is mixed with the curing agent, the filler, the curing accelerator, and the solvent to produce a resin composition. The resin composition in step 2 is in a semi-cured state.

In step 3, a surface of a thin base material is coated with the produced resin composition, and drying is further performed to volatilize the solvent. The base material is not particularly limited as long as it can be peeled off from the resin composition in a step described later, and as an example, an elongated PET sheet can be used. In addition, although there is no particular limitation in carrying out step 3, in a case of using an apparatus including a supply unit that supplies an elongated base material, a coating unit that is provided at downstream in a supplying direction and coats a surface of the base material with the resin composition, and a heating unit that is provided at upstream in the supplying direction and heats the resin composition passing through the heating unit at a predetermined temperature, the coating and drying can be continuously performed on the resin composition, and it is thus excellent in that step 3 can be carried out efficiently.

In step 4, the elongated base material coated with the resin composition is cut into a predetermined size to form a single sheet material in which the resin composition and the base material are laminated. In a case where a base material cut into a predetermined size in advance in step 3 is used, step 4 can be omitted.

In step 5, the resin composition with which the base material is coated is heated at a predetermined temperature for a predetermined time. Accordingly, a molecular weight (weight-average molecular weight) of the semi-cured resin composition can be increased. Although the molecular weight of the resin composition is also increased in step 5 and the subsequent steps, the total time required for producing the laminate 1 can be shortened by increasing the molecular weight of the resin composition in advance in step 5. In addition, in a case where the required molecular weight of the resin composition in any step is already obtained before step 5, step 5 may be omitted. A specific example for carrying out step 5 includes preparing a plurality of sheet materials each of which is formed by lamination of the resin composition and the base material described above, and heating the plurality of sheet materials together in a heating furnace.

In step 6, a compressive force is applied to the semi-cured resin composition. The resin composition before carrying out step 6 is in a state of containing a large number of voids therein because of drying in step 3, but step 6 enables an increase in the density to reduce the voids, and furthermore, enables the resin composition to be formed as an insulating layer with high insulating properties through a step described later. A specific example for carrying out step 6 includes overlaying the above-described sheet material onto the metal base substrate 2 illustrated in Fig. 1 so that the resin composition is in contact with the metal base substrate 2, placing those inside a vacuum press device, and pressing the overlaid metal base substrate 2 and sheet material in a state where the inside of this device is in a vacuum atmosphere at a predetermined temperature. Accordingly, the semi-cured resin composition can be transferred to the metal base substrate 2, and a compressive force can be applied to the resin composition. The metal base substrate 2 is not necessarily required to perform step 6, and for example, a separately prepared base material and the above-described sheet material may be overlaid and pressed, or a single sheet material may be pressed.

Although a gas can be discharged from the semi-cured resin composition by carrying out a step (step 8) with an autoclave described later, as a result of studies by the inventors of the present application, the gas may not be sufficiently discharged from the resin composition even though step 8 is carried out in a case where the curing of the resin composition proceeds too much. In addition, even though step 8 is performed in a state where the density of the resin composition is low, and a large number of voids are contained therein, it may be difficult to reduce the voids to such an extent that a sufficient withstand voltage can be obtained. In view of the above description, as a result of exhaustive studies for an optimal range of the molecular weight (weight-average molecular weight) and the density of the resin composition, the good result was obtained in a case where an increasing proportion of the weight-average molecular weight of the resin composition after step 6 (after the application of compressive force) was 30% or less based on before step 6 (before the application of compressive force). Furthermore, as a result of exhaustive studies on the increasing proportion of the weight-average molecular weight of the resin composition, a more preferable result was obtained in a case where the increasing proportion was 25% or less, and a still more preferable result was obtained in a case where the increasing proportion was 20% or less. In addition, a good result was obtained in a case where the density of the resin composition after step 6 (after application of compressive force) was 85% or more based on the actual density of the finally formed insulating layer. Furthermore, as a result of exhaustive studies on the density of the weight-average molecular weight of the resin composition, a more preferable result was obtained in a case where the density was 90% or less, and a still more preferable result was obtained in a case where the density was 95% or less. The weight-average molecular weight is a value in terms of polystyrene measured by a gel permeation chromatography (GPC) method.

In step 7, in a case where the base material is peeled off from the semi-cured resin composition transferred to the metal base substrate 2, or the resin composition is not transferred to the metal base substrate 2, the resin composition is transferred, followed by peeling off the base material from the resin composition. The circuit pattern 4 illustrated in Fig. 1 is then overlaid on the resin composition to form a laminate before press bonding 1A (see Fig. 3). In this step, the circuit pattern overlaid on the resin composition may be hot-pressed to temporarily bond the circuit pattern to the resin composition. The reference numeral 3A illustrated in Fig. 3 indicates a semi-cured resin composition.

In step 8, for example, the semi-cured resin composition 3A, which is laminated over the laminate before press bonding 1A, is cured by using an autoclave 10 and a film (bagging film) 11 having such a configuration as illustrated in Fig. 3. The autoclave 10 of the present embodiment includes a main body 10a and a lid body 10b. The main body 10a is provided with an exhausting passage 10c, and the lid body 10b is provided with a pressurizing passage 10d. Both or any one of the main body 10a or the lid body 10b is provided with a heater or other component that increases the temperature inside the autoclave 10. The film 11 is preferably a fluorine-based resin film having flexibility and excellent peelability. In performing this step, the present invention is not limited to the case of using only the film 11, and a cushion material or breather cloth may be used together with the film 11.

In step 8, the laminate before press bonding 1A is placed on the main body 10a and covered with the film 11, the lid body 10b is closed, and the film 11 is sandwiched between the main body 10a and the lid body 10b. Next, the inside atmosphere of the film 11 is exhausted by performing suction through the exhausting passage 10c, and the pressurized gas (air, nitrogen, or other gas) is sent through the pressurizing passage 10d to increase the pressure inside the autoclave 10, and the temperature inside the autoclave 10 is further increased by the heater. This state can be maintained for a predetermined time to cure the semi-cured resin composition 3A.

When step 8 is performed, the pressure inside the autoclave 10 is preferably 0.8 MPa or more and 3.0 MPa or less, the temperature inside the autoclave 10 is preferably 100°C or higher and 350°C or lower, and the time for maintaining the increased pressure and temperature is preferably 1 minute or more and 90 minutes or less. The pressure and temperature inside the autoclave 10 can be changed for the purpose of allowing the curing of the resin composition 3A to appropriately proceed, and may be set to be constantly maintained during the above time, or may be set to change over time.

By performing step 8, the film 11 not only comes in close contact with the surface of a conductive portion (metal portion) constituting the circuit pattern 4, but also reaches a gap portion located between conductive portions adjacent to each other and comes in close contact with the resin composition 3A exposed at the gap portion. That is, since the pressure inside the autoclave 10 is applied over the entire region of the resin composition 3A, the gas (gas contained in the voids and the residual solvent, volatile low molecular weight component, gas generated in association with an effect reaction, and the like) can be discharged from the entire region of the resin composition 3A.

In step 9, the laminate 1 taken out from the autoclave 10 is then fully cured. A specific example for carrying out step 9 includes putting the laminate 1 taken out from the autoclave 10 in a heating furnace and heating the laminate 1 at a predetermined temperature for a predetermined time. Accordingly, the semi-cured resin composition 3A can be fully cured. Step 9 is carried out in a case where the resin composition 3A is not fully cured in step 8, and in a case where the resin composition 3A is fully cured in step 8, step 9 is omitted.

In step 10, the laminate 1 in which the resin composition 3A is fully cured to form the insulating layer 3 is cleaned, and various inspections are performed.

As a result of confirming the laminate 1 produced through steps 1 to 10 described above, it was confirmed that the laminate 1 had a sufficient withstand voltage as described in Examples described later. In addition, even though the laminate 1 was repeatedly heated, peeling off between the insulating layer 3 and the circuit pattern 4 was not observed, and the result was good.

Examples of the present invention will be described below. Note that, the present invention is not limited to Examples.

### Examples

A bisphenol A epoxy resin (manufactured by DIC Corporation) was prepared as a thermosetting resin, diethyltoluenediamine (manufactured by Lonza Group AG) was prepared as a curing agent, aluminum oxide, an aggregate of boron nitride, and a fine powder of boron nitride were prepared as fillers, triphenylphosphine (manufactured by Hokko Chemical Industry Co., Ltd.) was prepared as a curing accelerator, and ethyl 3-ethoxypropionate was prepared as a solvent.

The thermosetting resin and the curing agent were then stirred at 70°C for 11 hours to form a prepolymer state (step 1). Subsequently, the above-described fillers, curing accelerator, and solvent were blended with the thermosetting resin in the prepolymer state and mixed with a mixer to produce a semi-cured resin composition (step 2).

Here, the weight-average molecular weight of the resin composition after step 2 was measured. The weight-average molecular weight measured is a value in terms of polystyrene measured by a gel permeation chromatography (GPC) method. The measurement was performed by using tetrahydrofuran (THF) as a mobile phase.
Measuring apparatus: Waters e2695 separation module
Differential refractive index (RI) detector: Waters 2414 RI Detector
Column: TSKgel guard column H
Column: TSKgel G1000H
Column: TSKgel G2000H
Column: TSKgel G3000H

Here, the weight-average molecular weight of the resin composition after step 2 was 487.

The produced resin composition was then applied on an elongated PET sheet and heated at 80°C for 40 minutes (step 3). Thereafter, the PET sheet coated with the resin composition was cut into a predetermined size (step 4). Thereafter, the cut sheet material was heated at 80°C for 20 minutes (step 5).

Here, the weight-average molecular weight and density of the resin composition after step 5 were measured. The method for measuring the weight-average molecular weight is the same as the measurement method after step 2. The density was measured by Archimedes method using an electronic balance HR-250AZ manufactured by A&D Company, Limited and a specific gravity measurement kit AD-1653. At this time, the weight-average molecular weight of the resin composition was 1,700, and the density was 1.87 g/cm³. The actual density of the insulating layer when the resin composition is fully cured through step 10 is 2.10 g/cm³ as measured by Archimedes method.

The sheet material after step 5 was then overlaid over the metal base substrate 2 so that the resin composition was in contact with the metal base substrate 2, and those were placed inside the vacuum press device. The overlaid sheet material and metal base substrate were then pressed at 23 MPa for 30 seconds in a vacuum atmosphere inside the device at 90°C (step 6).

Here, the weight-average molecular weight and density of the resin composition after step 6 were measured. The method for measuring the weight-average molecular weight and density is the same as the measurement method after step 5. At this time, the weight-average molecular weight of the resin composition was 1,900, and the density was 2.00 g/cm³. That is, an increasing proportion of the weight-average molecular weight of the resin composition in the present example is 11.8%, which is calculated by ((1900 - 1700)/1700) × 100%, after the step of applying the compressive force based on an increasing proportion before the step of applying the compressive force. In the present example, the density of the resin composition is 95.2%, which is calculated by (2.00/2.10) × 100%, after the step of applying the compressive force based on the actual density of the insulating layer.

Next, the PET sheet was peeled off from the semi-cured resin composition transferred to the metal base substrate 2, and the circuit pattern 4 (thickness of 1 mm) was further overlaid to form a laminate before pressure bonding (step 7).

Thereafter, as illustrated in Fig. 3, the laminate before pressure bonding is placed on a main body of an autoclave and covered with a film. After a lid body of the autoclave was then closed, an inside atmosphere the film was exhausted to increase the pressure and temperature inside the autoclave (step 8).

Step 8 was carried out in two ways of the following conditions A and B. The results will be described later.

### Condition A

The temperature inside the autoclave is maintained at 160°C for 18 minutes. The internal pressure is set to 0 MPa until 5 minutes elapse from the start, and pressurization is performed at 3 MPa until 18 minutes after 5 minutes elapse (during 13 minutes).

### Condition B

The temperature inside the autoclave is maintained at 180°C for 11.5 minutes. The internal pressure is set to 0 MPa until 5 minutes elapse from the start, and pressurization is performed at 3 MPa until 11.5 minutes after 5 minutes elapse (during 6.5 minutes).

Next, the laminate taken out from the autoclave was heated for 1 hour in a non-pressurized (atmospheric pressure) state at 185°C (step 9). Thereafter, cleaning was performed, and predetermined inspections were performed (step 10).

The laminate produced through steps 1 to 10 was then subjected to a withstand voltage test. Even though a voltage of 5 to 8 kV was applied to both the laminate produced under the condition A and the laminate produced under the condition B, no abnormality was observed, and the results were good. In addition, the laminate produced under the condition A and the laminate produced under the condition B were heated at 300°C for 5 minutes (after the first heating), and internal observation was then performed by using an ultrasonic flaw detector (SAT). As a result, peeling off between the insulating layer and the circuit pattern was not observed in any of the laminates. Even after the laminate was heated again at 300°C for 5 minutes (after the second heating) and after the laminate was further heated at 300°C for 5 minutes (after the third heating), peeling off between the insulating layer and the circuit pattern was not observed in the laminates produced under the conditions A and B, and the results were good.

Although one embodiment of the present invention has been described above, the present invention is not limited to the specific embodiment, and various modifications and changes can be made within the scope of the gist of the present invention described in the claims unless otherwise limited in the above description. In addition, the effects of the above embodiment are merely examples of the effects caused by the present invention, and the effects according to the present invention are not limited to the above effects.

### Reference Signs List

- 1: Laminate
- 1A: Laminate before press bonding
- 2: Metal base substrate
- 3: Insulating layer
- 3A: Semi-cured resin composition
- 4: Circuit pattern
- 10: Autoclave
- 11: Film

## Claims

1. A method for producing a laminate that is formed by lamination of a metal base substrate, an insulating layer formed by curing a resin composition, and a circuit pattern having a thickness of 0.8 mm or more, the method comprising:
a step of preparing a laminate before press bonding in which a semi-cured resin composition is interposed between the metal base substrate and the circuit pattern;
a step of covering the laminate before press bonding with a film and placing the laminate inside an autoclave; and
a step of exhausting an inside atmosphere of the film and increasing a temperature and a pressure inside the autoclave to cure the semi-cured resin composition.

2. The method for producing a laminate according to claim 1, further comprising a step of applying a compressive force to the semi-cured resin composition, the step being carried out before the step of preparing the laminate before press bonding is carried out.

3. The method for producing a laminate according to claim 2, wherein an increasing proportion of a weight-average molecular weight of the semi-cured resin composition after the step of applying the compressive force is 30% or less based on an increasing proportion before the step of applying the compressive force.

4. The method for producing a laminate according to claim 2 or 3, wherein a density of the semi-cured resin composition after the step of applying the compressive force is 85% or more based on an actual density of the insulating layer.
